# EUROPEAN PATENT APPLICATION

(11) **EP 1 416 460 A1**
(43) Date of publication of application: **06.05.2004**
(21) Application number: 02717167.7
(22) Date of filing: 16.04.2002
(51) Int. Cl.: G09F 9/00, G09F 9/30

(54) **MATRIX TYPE DISPLAY APPARATUS**

(30) Priority: 09.08.2001 JP 2001242370
(71) Applicant: Kabushiki Kaisha Toshiba, Minato-ku, Tokyo 105 (JP)
(72) Inventor: SUZUKI, Koji, Asahi-ku, Yokohama-shi, Kanagawa 241-081 (JP); NIKAIDO, Masaru, Yokosuka-shi, Kanagawa 239-0845 (JP); NISHIMURA, Takashi, Fukaya-shi, Saitama 366-0801 (JP)
(74) Representative: HOFFMANN - EITLE
(86) International application number: PCT/JP2002/003761
(87) International publication number: WO 2003/017238

(57) **Abstract**

A matrix type display apparatus comprises a display panel (11, 27) having a first main surface on which a display image is displayed and a second main surface substantially parallel to the first main surface, scanning lines (12) which are provided to the display panel and parallel to each other, signal lines (14) which cross the scanning lines and are parallel to each other, display pixels (17) provided at respective intersections of the scanning lines and the signal lines, and back side wirings (23) which are formed on the second main surface and connected with at least either the scanning lines or the signal lines at opposed end portions of the display panel.

## Description

### Technical Field

The present invention relates to a matrix type display apparatus such as an electron beam excited luminescent material display apparatus using a flat electron source (SCE emitter), a plasma display panel, or an electroluminescence (EL) display apparatus which utilizes the electroluminescence phenomenon of a luminescent material, and more particularly to a matrix type display apparatus with an improved wiring structure.

### Background Art

A display mode of exciting a luminescent material by using an electron beam has been widely used as a television apparatus using a cathode ray tube as a high-quality picture video apparatus. That is because this display mode has a high response speed and a wide visual angle characteristic and is applied to a luminescent type display apparatus.

However, a weight and a depth of the cathode ray tube are increased as a screen size becomes larger, and a 40-inch size is a limit in the prior art cathode ray tube. Therefore, 30-inch size or smaller cathode ray tube has been generally used for the domestic purpose. On the other hand, a picture signal of the NTSC type has been shifted to that of the high-vision type, and a display apparatus with a large screen is demanded with realization of higher quality.

Based on this, various kinds of matrix type thin flat display apparatuses have been studied and developed, and some of them have come into practical use.

As a recent large-screen thin display, there is an electron beam excited luminescent material display apparatus using a planar electron source (E. Yamaguchi, et. al., "A 10-in. SCE-emitter display", Journal of SID, Vol. 5, p345, 1997). This electron beam excited luminescent material display apparatus has the following merits. That is, an electron emission element array as a planar electron source can be formed by using a printing technique. This is based on the same luminescence principle as that of the cathode ray tube because in the luminescent material exited light emission using electrons. Further, the planar electron source can be driven with a voltage of over 10 V, and a drive IC with a low withstand voltage can hence be used.

As a field emission type electron source, there have been studied and developed an electron source which is of a so-called Spindt type, which sharpens the shape of an electron emission portion into a conical form and realizes the field concentration, an electron source using a carbon nanotube having a thickness in the order of nano-meters, and others, as well as the above-described planar electron source. Since the electrons subjected to field emission are accelerated with a high voltage of the kV order and the luminescent material is excited and caused to emit light, such electron sources have a characteristic capable of obtaining the same high quality as that of the cathode ray tube.

As another example of a large-screen display, a plasma display panel (PDP) which can realize a large-screen panel with a low cost by forming wirings or pixels based on a printing mode has come into practical use. Since this PDP uses the ultraviolet rays generated by discharge for each pixel to cause the luminescent material formed on a panel surface to emit light in order to obtain an image, it displays a picture based on the image generation principle similar to that of the cathode ray tube in theory. The difference from the cathode ray tube lies in that the luminescent material is excited and caused to emit light by using ultraviolet rays. Furthermore, the gray scale display is generally controlled by the number of discharges, realized by applying a pulse voltage of approximately 200 V.

Further, there has been also developed an electroluminescence matrix type display apparatus utilizing the electroluminescence (EL) phenomenon of luminescent material, i.e. an LED matrix type display apparatus, which injects electrons and electron holes and emits light with the carrier recombination energy. In the latter mode, a unimolecular or polymer organic material is used, and the material having the red, green and blue light emission characteristic is formed within the pixels, thereby enabling full-color display.

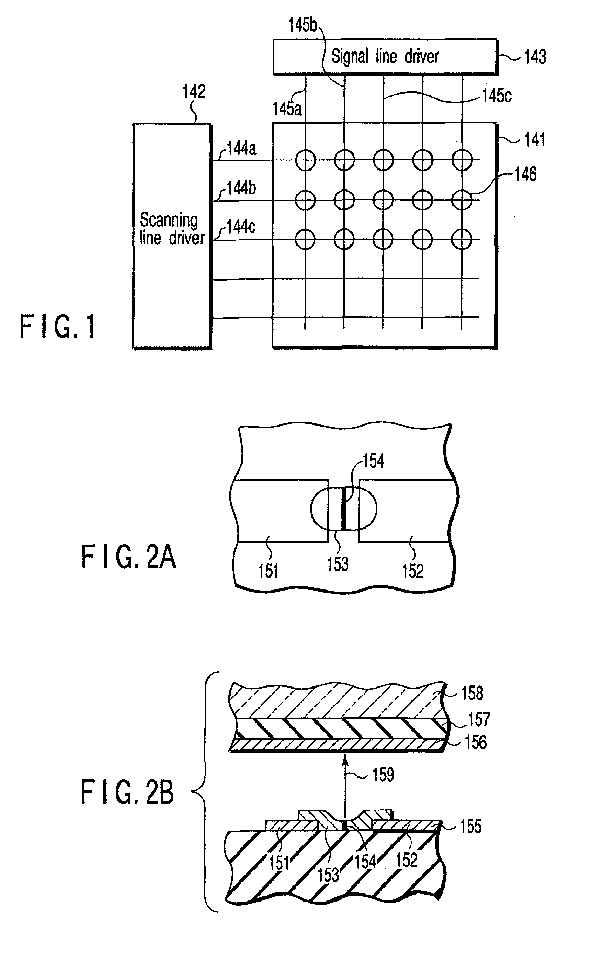

FIG. 1 shows a basic structural example of a prior art matrix type display apparatus. Scanning line wirings 144 (144a, 144b, ...) and signal line wirings 145 (145a, 145b, ...) are formed on a display area 141, and pixels 146 are provided at intersections of these wirings. The scanning line wirings 144 supply a control pulse voltage of a scanning line driver circuit 142 to each pixel, and the signal line wirings 145 supply a display signal voltage from a signal line driver circuit 143 to each pixel. The structure of each pixel varies depending on the display mode of the display panel.

FIGS. 2A and 2B are a plan view of an electron source constituted at a pixel of an electron beam excited luminescent material display panel using a field emission type planar electron source and a cross-sectional view of the display panel. Electrodes 151 and 152 and a conductive thin film 153 are formed on an insulating substrate 155, and an electron emission portion 154 is formed on a part of these members. Applying a voltage to the electron source from the electrodes 151 and 152 causes electron 159 to be emitted into a vacuum from the electron emission portion 154. The emitted electron flows into an anode electrode 156 formed on an opposed glass substrate 158.

If the anode voltage is sufficiently high and the anode electrode 156 is thin enough, the electron passes through the anode electrode 156 and is injected into a luminescent material layer 157, thereby causing the luminescent material 157 to emit light. Since the quantity of electrons to be subjected to field emission can be controlled based on a voltage applied to the electrode 151 and 152 or a voltage application time, the luminescent brightness can be changed.

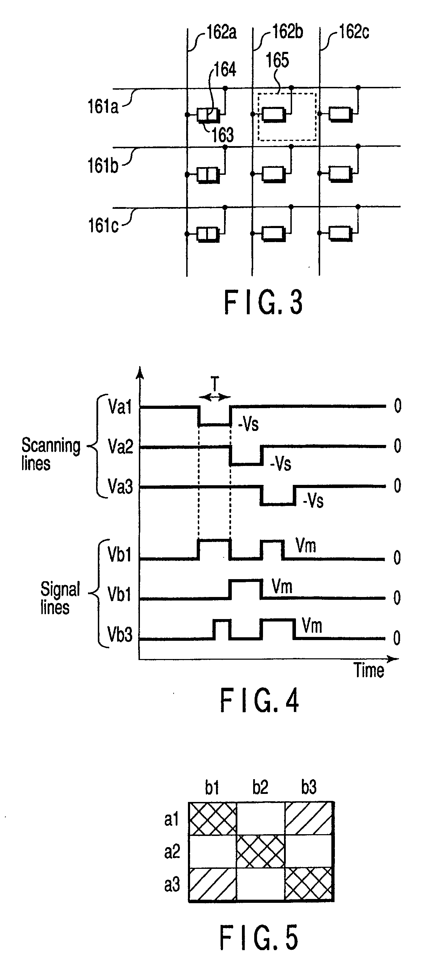

FIG. 3 shows the structure in more detail. Electron sources 163 are connected to scanning line wirings 161 (161a, 161b, ...) and signal line wirings 162 (162a, 162b, ...). Pixels 165 are provided at respective intersections of the scanning line wirings 161 and the signal line wirings 162, and an electron source 163 is formed for each pixel. Emission of electrons from an electron emission portion 164 of the electron source 163 is controlled by using a pulse voltage applied to the scanning line wirings 161 and the signal line wirings 162.

FIG. 4 shows an actual voltage pulse application method for this type of display panel. Reference characters Va1, Va2, Va3 ... denote waveforms of voltages applied to the scanning line wirings and correspond to voltage waveforms of the first, second and third scanning line wirings, respectively. After completion of application of the pulse voltage to all the scanning line wirings with a voltage waveform having a pulse width T and a voltage value -Vs, pulse application is again repeated from the first scanning line. Reference characters Vb1, Vb2, Vb3, ... designate pulse voltage waveforms of a display signal to be applied to the signal line wirings and correspond to voltage waveforms of the first, second and third signal line wirings, respectively. This pulse voltage is applied in synchronization with the scanning line pulse voltage, and its pulse width or voltage amplification value varies depending on the brightness. In this example, the brightness is controlled by using the pulse width.

A voltage value of the pulse voltage to be applied to the signal line wirings is Vm, and a difference from the voltage value of the scanning line wirings is applied to the flat electron source. Voltages of two levels, i.e., (0-(-Vs)) = Vs and (Vm-(-Vs)) = Vm+Vs are applied to the electron source of the scanning line wiring to which the voltage of -Vs is applied, namely, the electron source of the selected scanning line wiring.

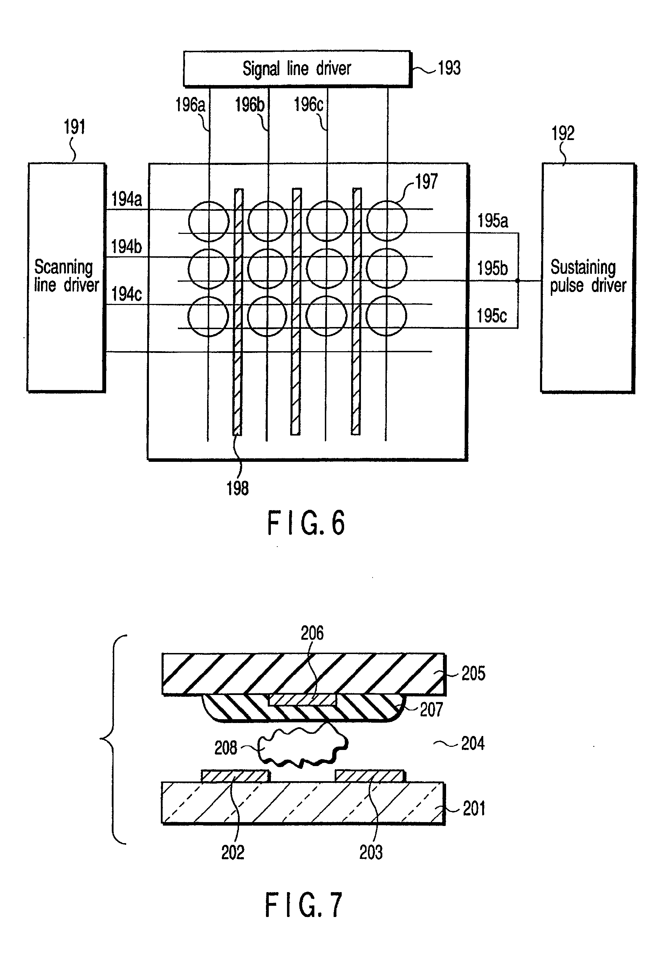

By setting Vs and Vm so that electron discharge of the electron source is enabled/disabled in each state, electrons are emitted from the electron source of the selected scanning line wiring to which the voltage of Vm is applied, and the luminescent material corresponding to this pixel emits light. Moreover, the brightness depends on a pulse width of the pulse voltage of the signal line wiring. FIG. 5 shows a display state of the pixel corresponding to voltage application depicted in FIG. 4.

Although the above has described an electron beam excited luminescent material display panel using a planar electron source, the current driven type LED display apparatus or a field driven type electroluminescent display apparatus is also a two-terminal display element connected to the scanning line wirings and the signal line wirings and driven by the method shown in FIGS. 3 to 5 in theory even though it has a structure different from that of the basic pixels depicted in FIGS. 2A and 2B.

The plasma display which causes the luminescent material to emit light by ultraviolet excitation based on plasma discharge adopts such a structure as shown in FIG. 6. A drive pulse is applied to scanning line wirings 194 (194a, 194b, ...) from a scanning line driver circuit 191, and a drive pulse is applied to signal line wirings 196 (196a, 196b, ...) from a signal line driver circuit 193.

In a plasma display, one discharge is completed by application of one voltage pulse, and discharge is not sustained, and hence a plurality of discharges must be generated in order to control the brightness. After the first discharge, continued application of the pulse voltage sustains discharge for the number of pulse applications by the memory effect, thereby enabling brightness control. Wirings to sustain this discharge are 195 (165a, 165b, ...), and a voltage is supplied from a sustaining pulse driver circuit 192.

In addition, application of a reset pulse can eliminate the memory effect. Pixels 197 are defined at intersections of the scanning lines, the signal lines, and the sustaining voltage wirings. It is to be noted that reference numeral 198 in the drawing denotes a partition to avoid discharge due to malfunction of an adjacent pixel.

FIG. 7 is a cross-sectional view showing a one-pixel portion structure of the plasma display. A scanning line wiring 202 and a sustaining pulse wiring 203 are formed on a glass substrate 201, and a dielectric film or the like is formed on the wirings, although not shown. A signal line wiring 206 is formed on an opposed substrate 205, and a luminescent material layer 207 is provided thereon.

When an address pulse voltage is applied to the scanning line wiring 202, a signal voltage pulse is applied to the signal line wiring 206, and discharge 208 occurs if a difference in potential between the both electrodes is sufficiently high. Immediately after this, the sustaining voltage pulse continues to be alternately applied to the sustaining pulse wiring 203 and to the scanning line wiring 202, thereby repeating the discharge 208. That is because the stored charge remains on the dielectric film on the electrodes 202 and 203 and provides the memory effect. Application of the reset pulse can eliminate the stored charge and reset the memory effect. Although the brightness is determined by the number of discharges, each pulse width is µ seconds or a shorter time because many discharges are produced within a limited scanning time.

As described above, although various matrix type display panels have different operating principles, the driving method can display an arbitrary image including the gray scale in theory, by applying the drive pulse voltages to the scanning line wirings and the signal line wirings orthogonal to each other. Such a matrix type display panel has been developed/come into practical use as a thin/lightweight large display apparatus, replacing the conventional cathode ray tube type which cannot be increased in size because of its depth and weight.

In the above-described matrix type display panel, drive signals are applied to the respective pixels through the scanning line wirings and signal line wirings. In the scanning line wirings in particular, since all pixels along the scanning line wirings are targets of the display operation when a selection pulse voltage is applied, and thus the load is large in view of the driver circuit. That is, in the field emission type electron beam excited fluorescent material display panel or the current driven type LED display panel, since a large current flows into the scanning lines, the voltage drops due to the wiring resistance.

On the other hand, in the field driven type electroluminescence display panel, the signal waveform is distorted due to the load capacity and the wiring resistance. Additionally, in the plasma display panel, since the voltage with a pulse width corresponding to a short time must be applied and the discharge current must be caused to flow, there occurs a problem of voltage drop due to an instantaneous large current besides the distortion of the voltage waveform.

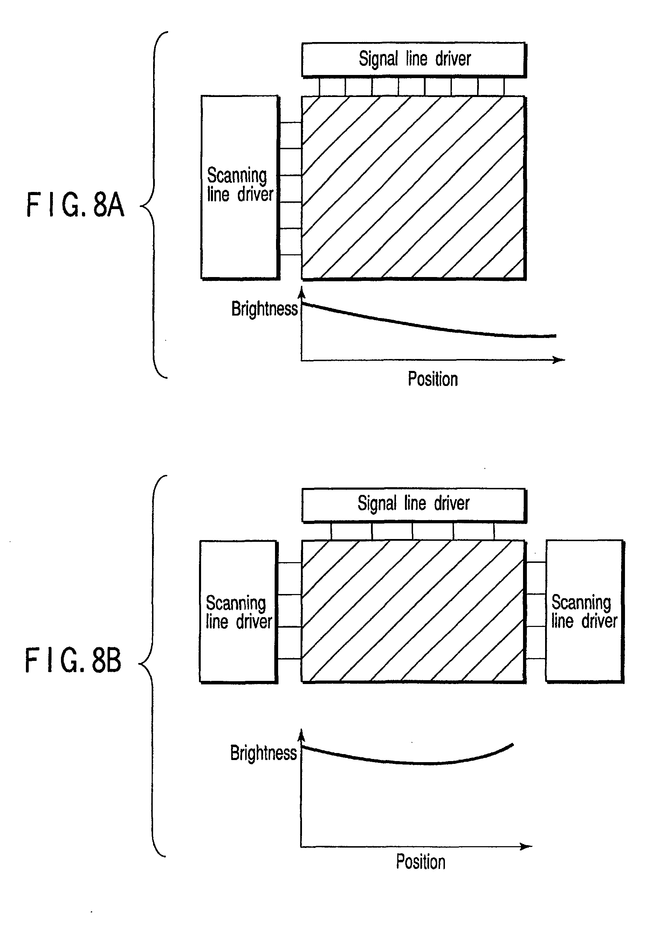

These problems generate an inclination of the brightness such as shown in FIG. 8A. In the plasma display panel, the voltage margin generated by discharge due to a voltage drop consequently differs on the right and left sides of the screen, and the operation margin is small, which makes it difficult to increase the dimensions and realize high definition.

As a method of avoiding this problem, driving from the both sides such as depicted in FIG. 8B can be considered. In this case, although the brightness is reduced at the central part in the screen, the amount of reduction is greatly eased as compared with that when driving on one side, and the inclination of the brightness becomes symmetrical, thereby considerably improving the display quality.

In the mode shown in FIG. 8B, however, the driver circuit must be doubled, which results in an increase in cost. Further, a slight difference in timing of the right and left drive circuits or a difference in application voltage causes problems such as an increase in power consumption or heat generation of the driver LSI, which also affects the performance of the display panel.

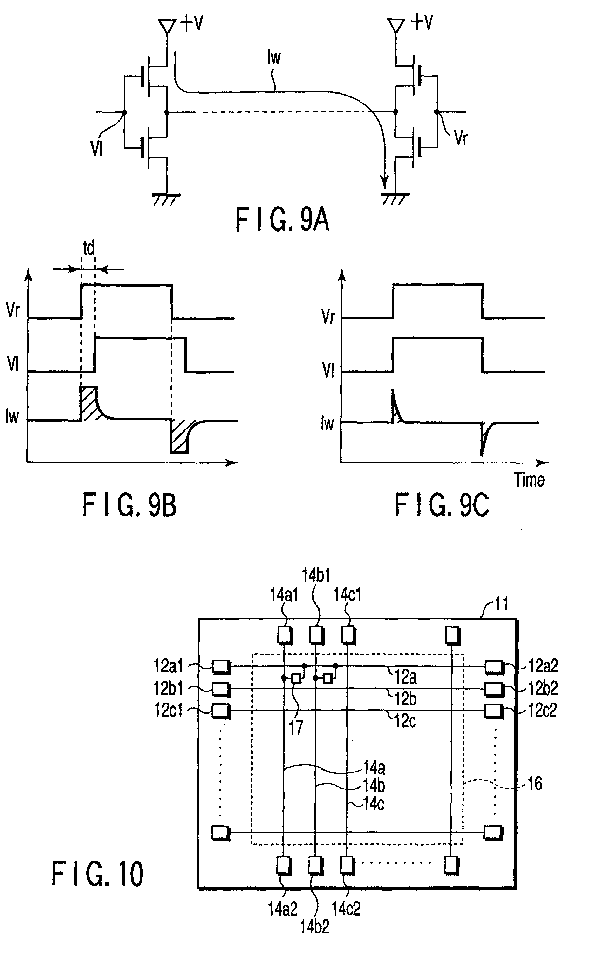

For example, in the voltage driven electroluminescence display panel or the plasma display panel, as shown in FIGS. 9A, 9B and 9C, a current flows through right and left CMOS driver circuits in a period that the right and left pulse voltages deviate from each other in time, and the reactive power is basically consumed with respect to the operation using only the charging current.

For example, FIG. 9B shows a case that a time difference between gate voltages Vr and Vl of the CMOS circuits provided on the right and left sides of the panel is large, and an illustrated current Iw flows in a lag time of Vl relative to Vr, and the reactive power is generated in this period. FIG. 9C shows a case that a lag time of Vl relative to Vr is small.

In particular, in the plasma display in which many high-frequency pulses are applied, heat generation of the circuits is large, and excessive heat generation elements are also produced. A deviation of the voltages of the right and left driver ICs causes generation of the reactive power through the driver LSI and, if the deviation is extremely large, the substrate reverse bias state of the transistor in the driver circuit changes to the forward bias state, which causes a large current to flow.

Therefore, there has been demanded realization of a matrix type display panel which can average the brightness in a display screen, and reduce the manufacturing cost and power consumption.

### Disclosure of Invention

According to a first aspect of the present invention, there is provided a matrix type display apparatus comprising:
a display panel having a first main surface on which a display image is displayed and a second main surface substantially parallel to the first main surface;
a plurality of scanning line wirings provided to the display panel and parallel to each other;
a plurality of signal line wirings provided in a direction crossing the plurality of scanning line wirings and parallel to each other;
a plurality of display pixels independent from each other, which are defined at respective intersections of the plurality of scanning line wirings and the plurality of signal line wirings; and
a plurality of back side wirings formed on the second main surface of the display panel and connected with at least one of the plurality of scanning line wirings and the plurality of signal line wirings at opposed end portions of the display panel.

According to a second aspect of the present invention, there is provided a matrix type luminescent material display apparatus comprising:
a first substrate having a first main surface and a second main surface substantially parallel to the first main surface; and
a second substrate arranged to be opposed to the first substrate with a predetermined gap maintained therebetween in vacuum, having a third main surface opposed to the first main surface and a fourth main surface substantially parallel to the third main surface and made of a transparent material,
the first substrate comprising:
   a plurality of scanning line wirings provided on the first main surface and parallel to each other;
   a plurality of signal line wirings provided on the first main surface in a direction crossing to the plurality of scanning line wirings and parallel to each other;
   a plurality of display pixels independent from each other, which are defined at respective intersections of the plurality of scanning line wirings and the plurality of signal line wirings and formed of field emission type electron sources; and
   a plurality of back side wirings provided on the second main surface and connected at least one of the plurality of scanning line wirings and the plurality of signal line wirings at opposed end portions of the first substrate,
   the second substrate comprising:
   an anode electrode formed on the third main surface to apply a voltage; and
   an electron beam excited luminescent material layer formed on the third main surface.

Furthermore, according to a third aspect of the present invention, there is provided a matrix type display apparatus comprising:
a substrate having a first main surface and a second main surface substantially parallel to the first main surface;
a plurality of scanning line wirings provided on the first main surface and parallel to each other;
a plurality of signal line wirings provided on the first main surface in a direction crossing the plurality of scanning line wirings and parallel to each other;
a plurality of display pixels independent from each other, which are defined at respective intersections of the plurality of scanning line wirings and the plurality of signal line wirings and made of a luminescent layer driven by a current or an electric field; and
a plurality of back side wirings provided on the second main surface and connected with at least one of the plurality of scanning line wirings and the plurality of signal line wirings at opposed end portions of the substrate.

Moreover, according to a fourth aspect of the present invention, there is provided a matrix type luminescent material display apparatus comprising:
a first substrate having a first main surface and a second main surface substantially parallel to the first main surface and made of a transparent material having; and
a second substrate arranged to be opposed to the first main surface of the first substrate with a predetermined gap maintained therebetween in a discharge gas, and having a third main surface opposed to the first main surface and a fourth main surface substantially parallel to the third surface,
the first substrate comprising a plurality of scanning line wirings provided on the first main surface and parallel to each other,
the second substrate comprising:
   a plurality of signal line wirings provided on the third main surface and parallel to each other in a direction crossing the plurality of scanning line wirings of the first substrate;
   an ultraviolet ray excited luminescent material layer formed on the third main surface at least at positions corresponding to a plurality of display pixels independent from each other which are defined at respective intersections of the plurality of scanning line wirings and the plurality of signal line wirings; and
   a plurality of back side wirings provided on the fourth surface and connected with at least one of the plurality of scanning line wirings and the plurality of signal line wirings at opposed end portions of the second substrate.

### Brief Description of Drawings

FIG. 1 is a view showing a structural example of a conventional matrix type display apparatus;
FIG. 2A is a plan view of an electron source constituted at a pixel of a display panel, and FIG. 2B is a cross-sectional view of the display panel;
FIG. 3 is a view showing a further concrete structural example of FIG. 1;
FIG. 4 is a view showing a method of applying a voltage pulse in an electron beam excited type luminescent material display panel;
FIG. 5 is a view showing a display state of a pixel corresponding to voltage application in FIG. 4;
FIG. 6 is a view showing a structural example of a plasma display apparatus;
FIG. 7 is a view showing a one-pixel structure of the plasma display panel;
FIGS. 8A and 8B are views showing the state of generation of a brightness inclination in the display apparatus;
FIGS. 9A, 9B and 9C are views for illustrating problems when drive circuits are provided on the right and left sides of the display panel, in which FIG. 9A is a circuit diagram of an output portion of the drive circuit, FIG. 9B shows a state of occurrence of a reactive current when a deviation of an input voltage is large, and FIG. 9C shows a state that a deviation of the input voltage is small;
FIG. 10 is a plan view showing a schematic structure of a matrix type display panel according to a first embodiment;
FIG. 11 is a cross-sectional view showing the display panel used in the first embodiment in a scanning line direction;
FIG. 12 is a plan view showing an entire structure of a back side wiring member;
FIG. 13 is a plan view showing a back side of a complete panel;
FIG. 14 is a plan view showing a schematic structure of a matrix type display panel according to a second embodiment;
FIG. 15A is a view showing a drive pulse voltage in the second embodiment, and FIG. 15B is a view showing a luminescent brightness distribution;
FIGS. 16A to 16G are type drawings for illustrating evaluation and an experimental method of an electromagnetic radiant noise of the display panel in the second embodiment;
FIG. 17A is a cross-sectional view showing a schematic structure of a matrix type display panel according to a third embodiment, and FIG. 17B is a plane view showing the same;
FIG. 18A is a cross-sectional view showing a schematic structure of a matrix type display panel according to a fourth embodiment, FIG. 18B is an enlarged cross-sectional view showing a pixel region, and FIG. 18C is a plan view;
FIG. 19A is a cross-sectional view showing a schematic structure of a matrix type display panel according to a fifth embodiment, FIG. 19B is a plan view;
FIG. 20 is a plan view showing a schematic structure of a matrix type display panel according to a sixth embodiment; and
FIG. 21 is a cross-sectional view showing the schematic structure of the matrix type display panel according to the sixth embodiment.

### Best Mode for Carrying Out the Invention

In the embodiments of the present invention which will be described next, either scanning line wirings or signal line wirings, or both, are connected with back side wirings formed on a back side of a substrate at both end portions of the substrate. Therefore, the voltage drop caused due to a wiring resistance of the scanning line wirings or the signal line wirings connected to the back side wirings can be reduced. Further, applying a drive pulse to the scanning line wirings or the like through the back side wirings can solve the problem of the brightness inclination generated by driving from one side. Furthermore, driving is enabled by one drive circuit, as compared with the structure providing drive circuits on both sides of the scanning line wirings, thereby avoiding an increase in cost and power consumption.

The embodiments according to the present invention will now be described with reference to the accompanying drawings.

### (First Embodiment)

FIGS. 10 to 13 are plan views showing a schematic structure of a matrix type display apparatus according to a first embodiment of the present invention.

In FIG. 10, scanning line wirings 12 (12a 12b, 12c, ...) are formed in the horizontal direction and signal line wirings 14 (14a, 14b, 14c, ...) are formed in the vertical direction on an insulating substrate (array substrate) 11 made of a glass substrate. Electrode terminals for external connection 12a1, 12b1, 12c1, ..., 12a2, 12b2, 12c2, ..., 14a1, 14b1, 14c1, ..., 14a2, 14b2, 14c2, ... are formed at both ends of the respective wirings. The number of scanning line wirings is 480, the number of signal line wirings is 640 × 3 (× 3 corresponds to pixels R, G and B), and wiring pitches are 900 µm and 300 µm, respectively.

Pixels are defined at respective intersections of the scanning line wirings 12 and the signal line wirings 14, and a planar electron source 17 which acts as an electron emission element is provided at each pixel. As a concrete structure of the planar electron source 17, one shown in FIGS. 2A and 2B is used, and the number of planar electron sources 17 is 480 in the scanning line direction and 640 × 3 in the signal line direction. The scanning line wirings 12 and the signal line wirings 14 are formed of an Ag paste by screen printing. Furthermore, both wirings are insulated from each other by an insulation layer formed by printing.

It is to be noted that a position indicated by a broken line 16 in FIG. 10 is a sealing region in which an array substrate (rear plate) 11 on which the electron sources 17 are formed is bonded to an opposed substrate (face plate) on which a luminescent material layer and an anode electrode are formed, and the rear plate and the face plate are sealed and connected by frit glass or the like after completion. At that time, the rear plate and the face plate are sealed with a gap of several mm.

Moreover, fluorescent substances which become red, green and blue at the luminescent wavelength peak are applied on the inner surface of the face plate, and a pattern of the face plate is formed with a pitch corresponding to each pixel on the rear plate. That is, the number of fluorescent substances for each of red light emission, green light emission and blue light emission is 480 in the scanning line direction and 640 in the signal line direction with a pitch of 900 µm.

A thin-film type aluminium layer is formed on the luminescent material layer, an anode voltage Va to accelerate electrons is applied thereto in the display operation. After sealing both plates, the inside of the display cells is vacuum-pumped through an exhaust tube provided outside the display region. The inside of the sealing region indicated by the broken line 16 in FIG. 10 becomes a vacuum region.

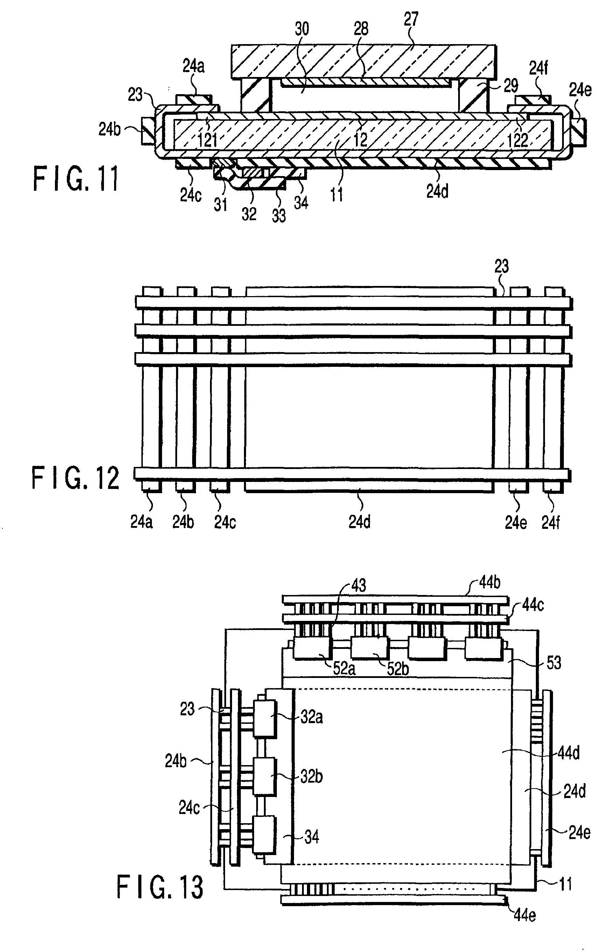

FIG. 11 is a cross-sectional view of the display panel used in this embodiment in the scanning line direction, and on the glass substrate 11 are provided the scanning line wirings 12, as well as the signal line wirings, the electron sources, and a spacer used to sustain the exhaust tube and the gap between both substrates, although not shown. On the face plate side, the luminescent material layer and an anode electrode 28 are formed on the glass substrate 27, the both substrates 11 and 27 are sealed in vacuum by the sealing region 29, and the inside 30 is vacuum-pumped through the non-illustrated exhaust tube.

The above-described structure is basically the same as the prior art apparatus, but back side wirings to improve the brightness inclination of the screen brightness are further provided in the present embodiment. That is, a plurality of back side wirings 23 are formed on the back side of the rear plate 11, and these back side wirings 23 are connected with electrode terminals 121 and 122 provided at the both ends of the scanning line wirings 12 at the both end portions of the substrate.

A drive IC 32 is provided on the back side of the rear plate 11, and this drive IC 32 is connected with the back side wirings 23 through a tape carrier 33 having a conductive layer on the surface thereof and an anisotropic conductive film 31. Furthermore, the drive IC 32 is connected with a circuit board 34 through the tape carrier 33. Moreover, the scanning line wirings 12 are driven by the drive IC 32. In this case, a drive pulse from the drive IC 32 is supplied to the scanning line wirings 12 via the back side wirings 23, and the scanning line wirings 23 are driven from the both ends 121 and 122 thereof.

FIG. 12 is a plan view showing the entire back side wiring member. Desired back side wirings 23 are formed by subjecting a copper-plated layer formed on a polymer film to a patterning and etching technique. A wiring resistance per back side wiring was 0.1 ohm. In addition, a part of the polymer film is removed and this film is divided into five regions 24a, 24b, 24c, 24d, 24e and 24f. As shown in FIG. 11, these regions are arranged so as to correspond to a part connected with wiring electrode terminals 121 and 122 or the like of the rear panel, a side surface portion of the rear panel and the back surface portion of the rear panel and others, and they act as a support which prevents the back side wirings from being electrically shortcircuited in the assembly process or from being disconnected due to mechanical shock or the like.

The drive IC 32 is arranged at a space portion of base films 24c and 24d and connected as shown in FIG. 11. It is to be noted that the surface of the copper wiring at the connection portion is preferably covered with a corrosion-resistant conductive film of e.g., gold, silver, nickel, solder, etc., to ensure good connection. In this embodiment, the copper surface of the connection portion is covered with the two-layer structure of copper/nickel/solder.
) Additionally, an anisotropic conductive film 31 is used for connection, and many connections are collectively performed.

FIG. 13 is a plan view showing the back side of the complete panel. The scanning line wirings are connected at the both ends through the back side wirings 23, these back side wirings 23 are connected to the drive ICs 32 (32a, 32b, ...), and the drive ICs 32 are connected to a circuit board 34 having a control circuit formed thereto. Similarly, the electrode terminals of the signal line wirings at the both ends thereof are connected through the back side wirings 43, and driven by drive ICs 52 (52a, 52b, ...). These drive ICs 52 are connected to a circuit board 53 and receive signals.

In the matrix type luminescent material display panel, which is of the electron beam excited type according to this embodiment, the operation is substantially the same as that when arranging the drive ICs on the both sides of the panel. Therefore, the brightness inclination of the display panel is substantially symmetrical, and can greatly improve the display quality as compared with the case that the display panel is driven from one side. Further, only one drive IC is provided for one wiring even though driving from the both sides is realized, thereby avoiding an increase in cost and power consumption.

### (Second Embodiment)

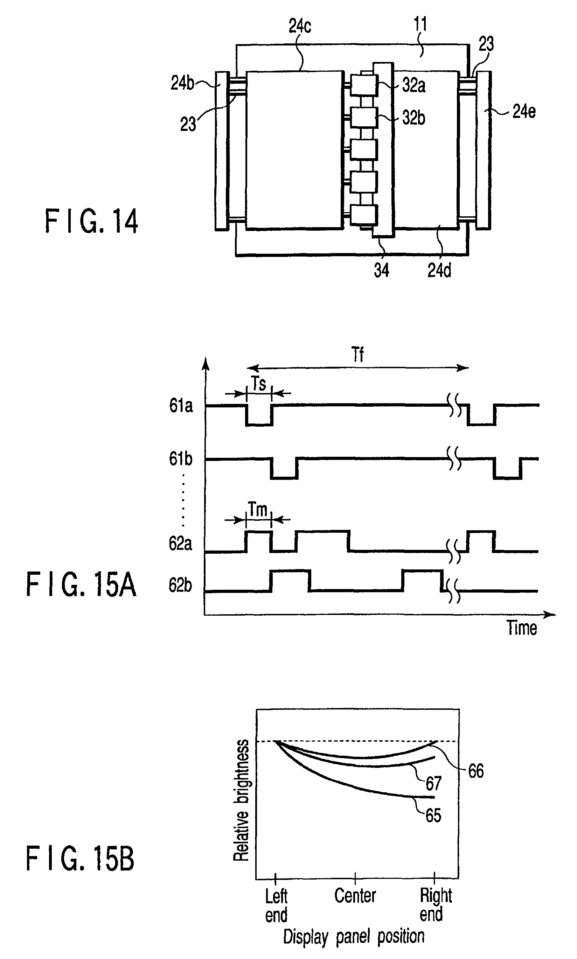

FIG. 14 is a plan view showing a schematic structure of a matrix type display apparatus according to a second embodiment of the present invention.

Although the basic panel structure is the same as that of the first embodiment, the back side wirings 23 on the back side of the rear plate 11 are provided on only the scanning line side, and the back side wiring connection portion of the drive ICs 32 (32a, 32b, ...) is provided at the central part of the back side wirings. These drive ICs 32 are connected to the circuit board 34 on which the control circuit is mounted. Reference numerals 24b to 24e denote polymer films which function as the base of the back side wirings 23. Although connection of the drive ICs on the signal line wirings side is not shown, the drive ICs are connected to the electrode terminals of the signal line wirings on one side thereof.

FIG. 15A show drive pulse waveforms of this panel. Voltage pulses of 61a, 61b, ... are sequentially applied to the scanning line wirings. Here, a pulse width of the drive pulse is 30 µ seconds, a cycle Tf is 16.67 ms (60 Hz), and a pulse voltage is -8V. On the other hand, voltage pulses of 62a, 62b, ... are applied to the signal line wirings, respectively. The voltage pulses of the signal line wirings and those of the scanning line wirings are applied in synchronization with each other. A maximum pulse width of the voltage pulses of the signal line wirings is 30 µm, and the pulse width is narrowed when the brightness is insufficient. A voltage value is 8 V.

In the display operation, first, a voltage of 16 V is applied to the electron source of the pixel portion where a selection voltage of -8 V is applied to the scanning line wiring and a display voltage of 8 V is simultaneously applied to the signal line, and the electron is emitted from the electron source. The emitted electron is accelerated at the anode electrode to which a high voltage is applied (6 kV in this embodiment), injected into the luminescent material layer, and emits light.

On the other hand, since only the voltage of -8 V is applied to the electron source corresponding to the signal line wiring to which the voltage pulse of 0 V is applied, electron emission does not occur, and the light is not emitted. Moreover, since the voltage required for electron emission is not applied to the electron source corresponding to the scanning line wiring to which no selection voltage is applied, light is not emitted. As described above, sequentially applying the voltage pulses to the scanning line wiring and the signal line wiring can realize a desired display.

In the planar electron source of this embodiment, a current which flows into the element when it is selected (when 16 V is applied to the electron source) is 0.2 mA. Therefore, the total current flowing when all the electron sources of the scanning line wirings are selected is 640 × 3 × 0.2 = 384 mA. A resistance per scanning line wiring is approximately 0.6Ω, and a voltage difference of 0.32 V is generated at the drive end and the electrode terminal portion provided on the side opposite to the drive end (in the case of a simple resistance × current model) when passing all the currents from one electrode terminal of the scanning line wiring.

Since the electron emission characteristic of the electron source is the non-linear characteristic of Fowler-Nordheim, a voltage drop of 0.23 V corresponds to a difference of approximately 30% when converted to an emitted electron flow. That is, when driving from one side, there is provided the brightness inclination of 30% on the right and left sides of the screen under this condition. This state is indicated by 65 in FIG. 15B.

On the other hand, in this embodiment, since driving is performed from the both sides of the scanning line wirings, a voltage drop is approximately 0.06 V even at the central part in the screen which is mostly affected by the voltage drop, and the brightness reduction relative to the right and left regions of the screen is approximately 8% (66 in FIG. 15B).

As described above, it is possible to greatly decrease the brightness inclination which is a problem in one-side driving in the prior art. Moreover, although the both-side driving requires the drive ICs whose number is twofold that of the drive ICs in the one-side driving in the prior art, the drive ICs whose number is equal to that in the one-side driving can realize the same excellent display quality as that of the both-side driving in this embodiment.

It is to be noted that the back side wirings are provided on only the scanning line side in this embodiment. That is because the current flowing into the signal line corresponds to one selected pixel in the matrix type display panel using this electron source, and the current is as small as 1 mA or below, which is not affected by the wiring resistance. Of course, when the electron source current is large, when the leak current of the non-selected electron source is large, or when the wiring resistance is considerably high, providing the back side wirings on both the scanning line side and the signal line side can improve the display image quality like the first embodiment.

67 in FIG. 15B shows an in-screen brightness distribution in the first embodiment. Since the drive IC 32 is not provided at the central part of the back side wirings, the resistance of the back side wirings has an impact. However, since the resistance per back side wiring is as small as 0.1Ω, the impact is slight, and a reduction in the maximum brightness is also not more than 10%.

When the back side wiring resistance is not negligible with respect to wirings on the rear panel, it is desirable to drive from the vicinity of the central part of the back side wirings like the second embodiment. Specifically, when the back side wiring resistance is larger than the resistance of the scanning lines or the signal lines connected with the back side wirings, driving from the central part is desirable.

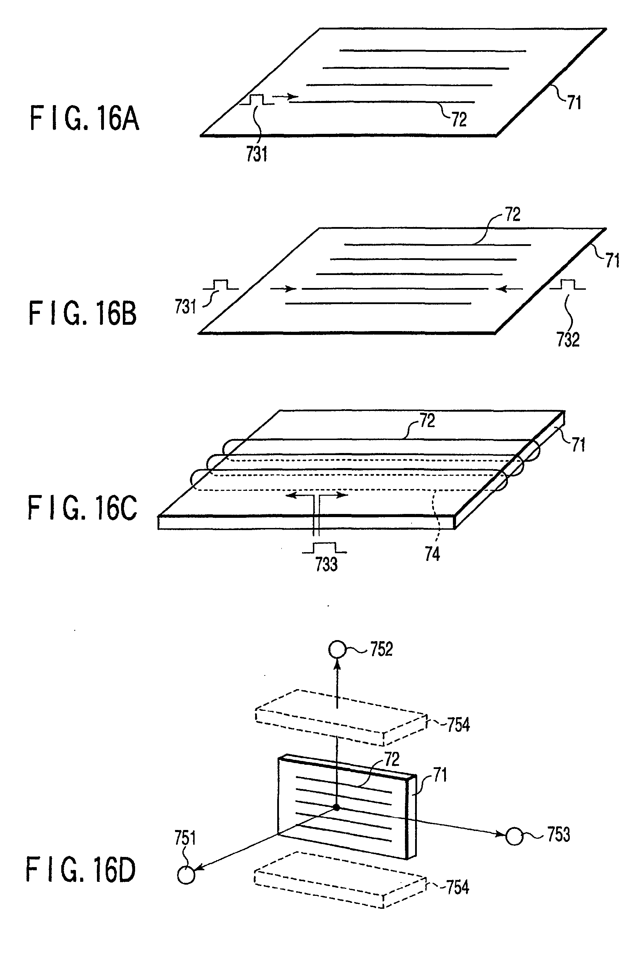

Another advantage of the present invention will now be described with reference to FIGS. 16A to 16G. In the matrix type display apparatus, the display signal is applied to each of the pixels of the million order, and hence electrical signals used for display are transferred at a high speed. Therefore, the electromagnetic noise is radiated from the display panel including the peripheral drive circuits, and such noises must be restricted. In the display apparatus of this embodiment, the pulse current of 0.38 A flows through each scanning line, and the electromagnetic noise corresponding to this flow of current is thus radiated.

The pulse voltage of 15V with a width of 30 µs and a cycle of 60 Hz is sequentially applied to the scanning line wirings of the rear plate (FIGS. 16A and 16B) having the conventional structure. Here, FIG. 16A shows the one-side driving, and FIG. 16B shows the both-side driving in the conventional structure. Furthermore, FIG. 16C shows driving of the rear plate according to this embodiment, and the same pulse voltage was applied from the central part of the back side wirings 74. Then, the radiant noise was measured on a front surface 751 of the rear plate, in a direction 752 vertical to the scanning line wirings in the plane of the rear plate and in a direction 753 parallel to the scanning line wirings in the plane of the rear plate. Incidentally, as to a distance, measurement was carried out at a position away from the central part of the rear panel by 2 m.

Comparing the energy with a frequency component having a largest radiant noise, the following values were obtained in relative values with the front surface position 751 in FIG. 16A as a reference.

| Position | One-side driving | Conventional two-side driving | This embodiment |
|---|---|---|---|
| 751 | 1 | 1 | 0.4 |
| 752 | 1.5 | 1.4 | 1.8 |
| 753 | 0.3 | 0.2 | 0.1 |

On the front surface of the rear plate, namely, on the front surface of the display panel, the radiant noise from the rear plate of this embodiment is smallest. The reason can be considered as follows.

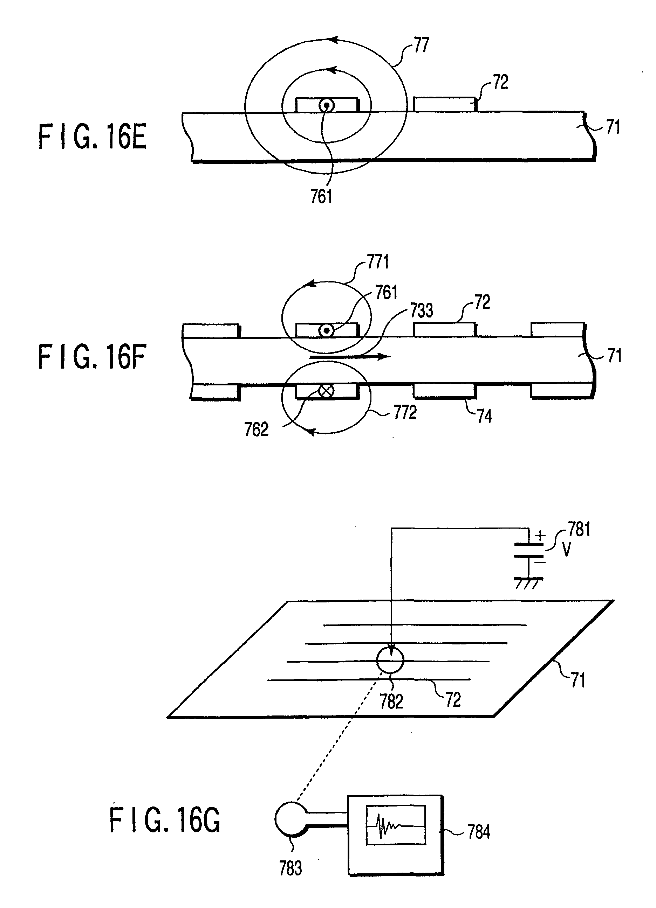

FIG. 16E shows the cross section of the rear plate having the conventional structure, and a magnetic field 77 is generated around a current 761 when the current 761 (reference symbol indicates that the current direction runs from underneath to the surface of the page) flows through the wiring 72. A spatial distribution of this magnetic field is basically concentric, and becomes equal in the vertical direction of the substrate 71 and the horizontal direction in the drawing.

However, in the rear plate of this embodiment, as shown in FIG. 16F, since the wiring system forms a loop, it can be understood that the magnetic field is small in the vertical direction of the rear plate but the magnetic field has a double intensity in the horizontal direction of the substrate. That is, the back side wirings of this embodiment form one kind of loop antenna, and the radiant noise has directivity. Moreover, the wiring groups arranged in parallel constitute an antenna system which increases the directivity. Therefore, it was found that the structure of this embodiment can greatly reduce the radiant noise in the vertical direction of the display panel.

It is to be noted that the radiant noise increases in the direction of 752 in FIG. 16D but provision of a shield plate 754 or the like which blocks off the electromagnetic noise to a casing can suppress the radiant noise.

On the other hand, such a shield measure is difficult in the direction 751 which is an observation direction of the display panel. Although the anode electrode is formed on the face plate opposed to the substrate 71 in the display panel of this embodiment, this anode electrode is generally a very thin film of Al with a thickness of approximately 0.1 µm which reflects the emitted light from the luminescent material layer, thus shielding of the radiant noise is difficult.

In addition, in the matrix type luminescent display panel which is of the electron beam excited type using the field emission type electron sources, a high voltage of several kV is applied to the anode electrode. Discharge due to foreign particles in the panel may occur between the rear plate and the face plate in some cases. In such a case, the discharge current instantaneously flows through the matrix wirings. This impulsive noise has a high voltage and hence is greater than the radiant noise generated in the regular operation by a single digit or more.

FIG. 16G shows an experimental method of the radiant noise caused due to discharge, and a high voltage is applied to a capacitor 781 in advance and its charge is discharged (782) to the wirings on the rear plate. The noise generated at that moment was received by a small loop antenna and a generated voltage was measured by using an oscilloscope.

As a result, it was found that the magnitude of the electromagnetic noise radiated in the direction of the front surface of the rear plate can be reduced to approximately 1/10 in the rear plate according to this embodiment, as compared with the rear plate wiring structure having the conventional structure. It was revealed that the electromagnetic radiant noise generated from the display panel can be greatly reduced by the back side wiring structure as described above.

As to this electromagnetic radiant noise, the effect is particularly high in the electron beam excited type luminescent material display panel using a high voltage, an electroluminescent type display panel having a high pulse voltage, an ultraviolet ray excited type luminescent material display panel having a high pulse voltage and a high drive frequency (so-called plasma display) and the like.

### (Third Embodiment)

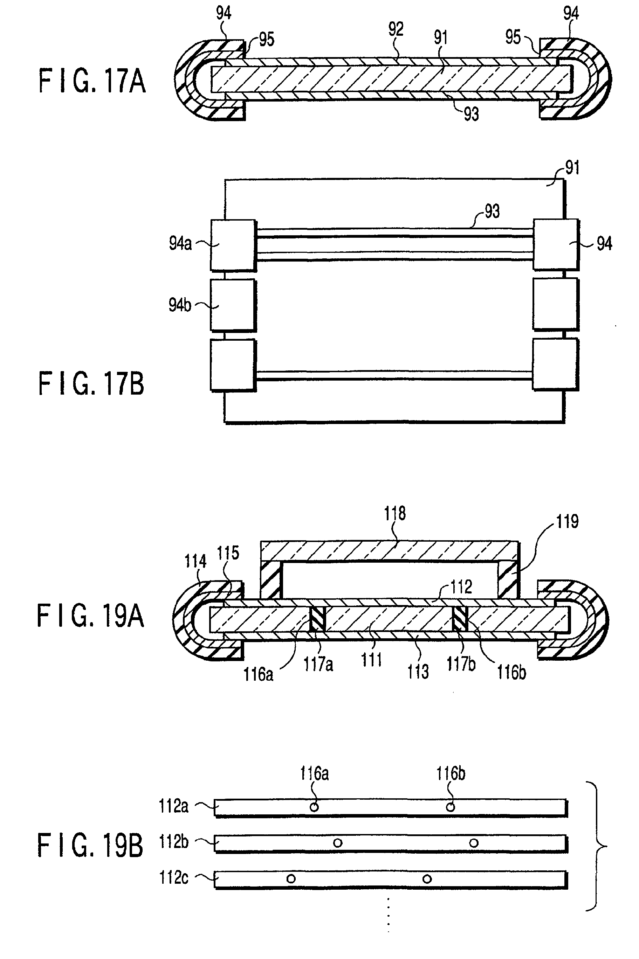

FIGS. 17A and 17B are a cross-sectional view and a plan view showing a schematic structure of a matrix type display panel according to a third embodiment of the present invention.

The mode, the number of pixels, etc., of the display panel are equal to those in the second embodiment, but the back side wirings are formed of thin-film wirings in this embodiment. That is, after forming scanning line wirings 92 as well as an interlayer insulating film and signal line wirings, which are not shown, on the front side of a glass substrate 91 as the rear plate, a chrome thin film with a thickness of 0.1 µm is formed on the back side by the sputtering method, and a copper thin film with a thickness of 20 µm and a nickel thin film with a thickness of 0.1 µm are formed by sputtering. Thereafter, back side wirings 93 are formed by patterning of a photoresist and succeeding etching. Then, planar electron sources are formed on the surface of the rear plate, and the rear plate is positioned, sealed and bonded with the face plate. Then, the inside of the display cell is vacuum-pumped through a non-illustrated exhaust tube.

Subsequently, the scanning line wirings 92 on the surface of the rear plate are connected with the back side wirings 93 by using wirings 95 which are formed on a polymer film 94 at the end surface portions of the substrate and mainly include copper. Finally, although not shown, the drive ICs are connected to the back side wirings 93, and they are further connected to a control circuit, thereby completing the display panel.

In this embodiment, using the thin-film wirings as the back side wirings 93 can directly form the back side wirings 93 on the back side of the substrate, which results in advantages such as a decrease in the number of components or reduction in thickness of the panel, amongst others.

It is to be noted that a copper or copper alloy foil may be etched and punched out as another method of forming the back side wirings. In this case, since the thickness of the wirings can be increased, the back side wirings with a low resistance can be realized. Such wirings may be bonded on the back side of the rear plate in order to form the back side wirings appressed against the substrate such as shown in FIGS. 17A and 17B.

Also, regular electric wires covered with an organic insulating film or a so-called enameled wire having an insulating substance applied on the surface thereof may be likewise used. In this case, it is recommendable to tightly align and fix several wires in parallel and flatly. When a so-called flat cable is used, it can be readily connected with an all-purpose connector which facilitates connection with the drive IC or the drive circuit board, thereby enabling assured connection in a simple process.

### (Fourth Embodiment)

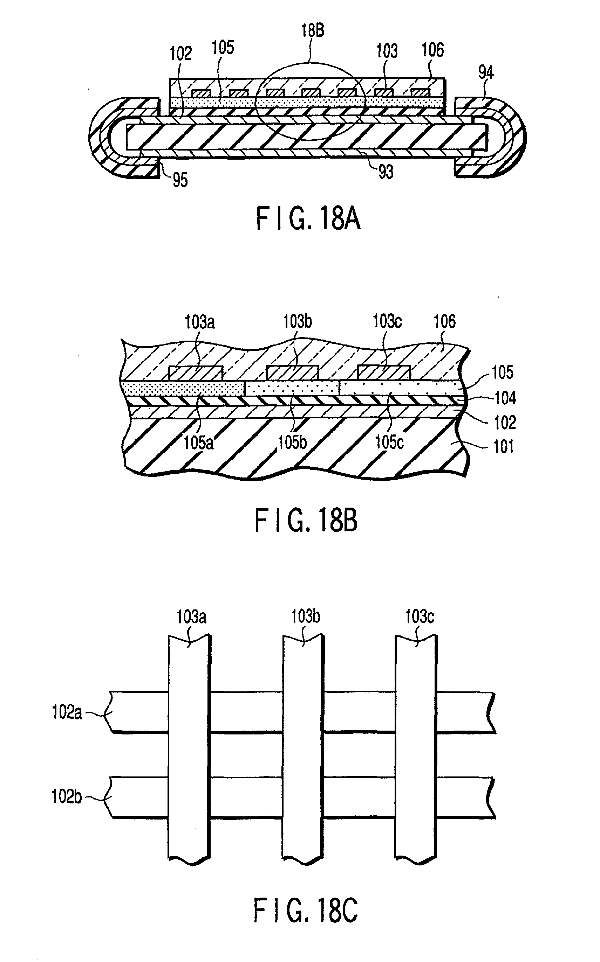

FIGS. 18A and 18B are cross-sectional views showing a schematic structure of a matrix type display apparatus according to a fourth embodiment of the present invention, and FIG. 18C is a plan view.

In the matrix type display apparatus of this embodiment, an electroluminescence material is used for a luminescent layer. The basic structure is the same as that shown in FIG. 10, and the number of scanning line wirings is 480 while the number of signal line wirings is 640. Pixels are defined at intersection areas of scanning line wirings 102 (102a, 102b, ...) and signal line wirings 103 (103a, 103b, 103c ...). That is, applying the electric field to the insulating layer including the luminescent layer sandwiched between the overlap parts of the both wirings can provoke emission of light, and this whole area acts as display pixels.

FIG. 18A is a cross-sectional view showing a display panel, FIG. 18B is an enlarged cross-sectional view showing a pixel area (indicated by 18B in FIG. 18A), and FIG. 18C is a plan view.

Scanning line wirings 102 are formed of a chrome thin film on the front side of a substrate 101, an MgO dielectric material layer 104 and a luminescent layer 105 mainly including ZnS are superimposed and formed on the scanning line wirings 102, and signal line wirings 103 are formed on these layers. That is, the dielectric material layer 104 and the luminescent layer 105 are sandwiched and provided between the both wirings 102 and 103.

The signal line wiring 103 is formed by a transparent electrode (ITO film is used in this embodiment), and transmits light from the luminescent layer 105 therethrough. Further, each signal line wiring 103 on the front side of the substrate is protected by a nitride film (SiNx) 106.

In this embodiment, ZnS which emits monochromatic light is used for the luminescent material layer, but full-color display is also enabled by forming luminescent materials for red luminescence, green luminescence and blue luminescence in accordance with each pixel (FIG. 18B).

Furthermore, in this embodiment, like FIG. 17A of the third embodiment, the back side wirings are formed by thin film wirings 93, and wirings 95 formed on polymer films 94 at end surface portions of the substrate and mainly including copper are used to connect the thin film wirings 93 on the back side of the substrate with the scanning line wirings 102. Moreover, the drive IC is provided at the central part of the back side wirings although not shown.

The back side wirings are not restricted to the above-described type and, like FIG. 14 of the second embodiment, back side wirings 23 each of which is based on a polymer film and mainly including copper may be connected at both ends of the scanning line wiring 102 and provided on the back side.

In the electroluminescence display panel, the dielectric material is formed between the both wirings, and this can be basically regarded as wirings of the capacitive load. Therefore, as the circuit configuration of the output portion of the drive IC, such a CMOS structure as shown in FIG. 9A is desirable, and supply of the current from the drive IC is stopped when the wirings are charged up and reach a predetermined potential.

When driving the conventional electroluminescence display panel from one side, signal delay of the wirings occurs because of the large capacitive load, and a brightness difference is apt to be produced between the drive end side and the opposite side thereto.

In this embodiment, the chrome thin film is used for the scanning line, the wiring resistance is approximately 10 kΩ, the wiring capacitance is 600 pF, and the simple wiring time constant is 6 µs (microseconds). These are non-negligible values relative to the selection pulse width of 30 µs of the scanning line.

In order to avoid the brightness inclination, irregularities in display are improved by connecting the drive ICs to the both ends of the wirings. However, as shown in FIG. 9B, the loss current flowing through the drive ICs appears in a phase lag period td of the pulse voltages of the drive ICs on the both sides of the wirings, and there occur problems of an increase in power consumption or heat generation of the drive ICs.

On the contrary, in this embodiment, the number of drive ICs is one, and such problems do not occur. That is, in the electroluminescence display panel according to this embodiment, driving from the both sides is enabled with the minimum number of the drive ICs equal to that of conventional one-side driving, no brightness inclination occurs, and display with the excellent uniformity can be realized. Also, the effect that generation of the excessive power consumption can be suppressed was confirmed.

In addition, like FIG. 16D of the second embodiment, it is effective to provide the shields 754 so as to be opposed to the panel end portions in the direction vertical to the extending direction of the back side wirings.

### (Fifth Embodiment)

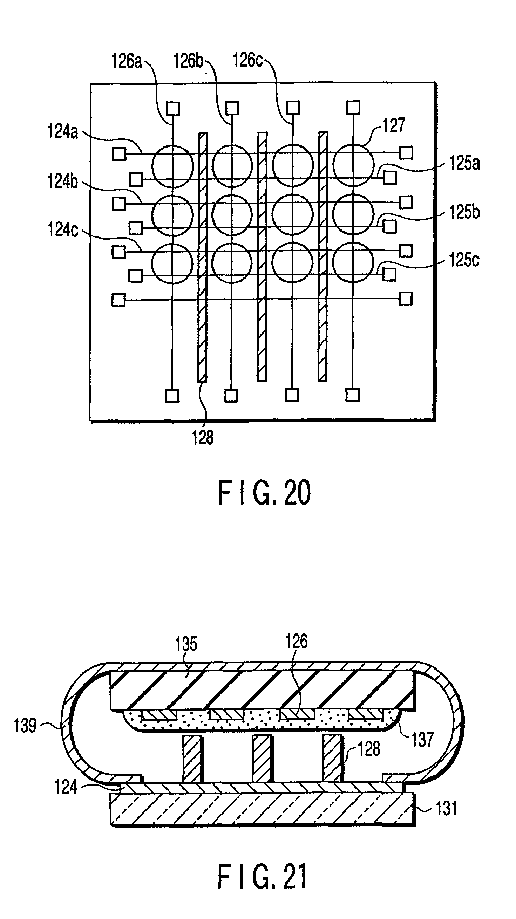

FIG. 19A is a cross-sectional view showing a schematic structure of a matrix type display panel according to a fifth embodiment, and FIG. 19B is a plan view showing the same.

The mode of the display panel, the number of pixels and others are equal to those of the third embodiment. In this embodiment, however, the back side wirings and the wirings on the rear plate to be connected with the back side wirings are connected to each other via conductive through holes provided on the substrate.

In further detail, the through hole is first formed by ultrasonic processing at a position on the glass substrate 111 as the rear plate where the scanning line wiring is formed. Conductive portions 116 (116a, 116b) are lined by the silver paste on the inner glass surfaces of the through holes 116, and the remaining hollow portions are filled with frit glass 117 (117a, 117b) and sintered.

In this embodiment, two conductive through holes are formed for each scanning line wiring. Additionally, as to positions of the holes, as shown in FIG. 19B, the holes are arranged in such a manner that their positions are shifted from each other at adjacent wiring portions thus damage to the substrate due to concentration of stress at a specific position of the substrate is not generated.

Subsequently, after forming the scanning line wirings 112 as well as the interlayer insulating film and signal line wirings which are not shown, a chrome thin film having a thickness of 0.1 µm is formed on the back side by the sputtering method, and a copper thin film having a thickness of 20 µm and a nickel thin film having a thickness of 0.1 µm are further formed by the sputtering method. Thereafter, the back side wirings 113 are formed by patterning a photoresist and successive etching. Here, the back side wirings are formed at positions which match with the corresponding through holes of the scanning line wirings.

Then, planar electron sources are formed on the surface of the rear plate, the rear plate is positioned with the face plate, and they are sealed and bonded with each other. Further, the inside of the display cell is vacuum-pumped through a non-illustrated exhaust tube.

Subsequently, the wirings 115 which are formed on the polymer films 114 at the end surface portions of the substrate and mainly include copper are used to connect the scanning line wirings 112 on the surface of the rear plate with the back side wirings 113.
Finally, although not shown, the drive IC is connected with the back side wirings 113, and they are further connected with the control circuit, thereby completing the display panel.

In this embodiment, since the back side wirings 113 are provided on the back side of the rear plate 111 and connected with the both end portions of the scanning line wirings 112, the voltage drop due to the wiring resistance of the scanning line wirings 112 can be reduced. Furthermore, since the drive pulse voltage can be applied to the central part of the scanning line wirings 112 from the back side wirings 113 side via the through holes, a decrease in voltage can be further reduced. Therefore, the uniformity of display can be further improved. Specifically, irregularities in brightness of display can be improved to 2% or below.

It is to be noted that the through hole in this embodiment can be applied to the substrate of the electroluminescence display panel shown in FIG. 18A of the fourth embodiment.

### (Sixth Embodiment)

FIG. 20 is a plan view showing a schematic structure of a matrix type display panel according to a sixth embodiment of the present invention. This embodiment is an example of a plasma display which causes a luminescent material to emit light by ultraviolet ray excitation using plasma discharge.

Drive pulses are applied to scanning line wirings 124 (124a, 124b, 124c, ...) from a non-illustrated scanning line driver circuit, and drive pulses are applied to signal line wirings 126 (126a, 126b, 126c, ...) from the non-illustrated signal line driver circuit. In the plasma display, one discharge is effected by one application of the voltage pulse and discharge is not sustained, and hence a plurality of discharges must be generated in order to control the brightness. Continuing application of the pulse voltage after the first discharge can sustain discharge for the number of pulse applications by the memory effect, thereby enabling brightness control. Wirings to sustain this discharge are 125 (125a, 125b, 125c, ...), and the voltage is supplied from a non-illustrated sustaining pulse driver circuit.

Furthermore, the memory effect can be eliminated by application of the reset pulse. Pixels 127 are defined at intersections of the scanning lines, the signal lines and the sustaining voltage wirings. It is to be noted that reference numeral 128 in the drawing denotes a partition used to avoid discharge due to malfunction of the adjacent pixels.

FIG. 21 shows a cross section of the plasma display panel, and scanning line wirings 124 and sustaining pulse wirings 125 (not shown) are formed on the front side of a glass substrate (first substrate) 131. Moreover, although not shown, a dielectric material film and others are formed on the wirings. An opposed substrate (second substrate) 135 is provided with its front surface being opposed to that of the glass substrate 131, signal line wirings 126 are formed on the front surface of the substrate 135, and a luminescent material layer 137 is provided thereon.

The substrates 131 and 135 are supported with a predetermined gap maintained therebetween in such a manner that the respective wirings 124 and 126 are aligned so as to be orthogonal to each other, and a discharge gas is filled between the both substrates. Back side wirings 139 are provided on the back side of the second substrate 135, and these back side wirings 139 are provided so as to extend to the both sides of the second substrate 135 and connected with the scanning line wirings 124 on the first substrate 131 side at the both end portions of the substrate.

When an address pulse voltage is applied to the scanning line wirings 124, a signal voltage pulse is applied to the signal line wirings 126, and discharge is produced if a potential difference between the both electrodes is sufficiently high. Immediately after this, a sustaining voltage pulse is alternately applied to the sustaining pulse wirings 125 and the scanning line wirings 124, thereby repeating discharge. That is because the stored charge remains on the dielectric material film on the wirings 124 and 125 and the memory effect is provided. Application of a reset pulse can eliminate this stored charge and reset the memory effect. Although the brightness is determined by the number of discharges, each pulse has a width of a µs or less in order to generate many discharges within a limited scanning time.

In this embodiment, connecting the back side wirings 139 provided on the second substrate 135 side with the scanning line wirings 124 provided on the first substrate 131 side at the both end portions can reduce the voltage drop due to the wiring resistance of the scanning line wirings 124 and restrict the unevenness of the brightness.

### (Modification)

It is to be noted that the present invention is not restricted to each of the above embodiments. Although the electron beam excited type display apparatus using the planar electron sources or the electroluminescence type display apparatus has been described in the foregoing embodiments, the present invention is not restricted thereto, and it is possible to adopt any other excited electron beam type display apparatus, e.g., an apparatus which is of a type using Spindt electron sources or electron sources using carbon nanotubes. Furthermore, it is also possible to employ any other display apparatus, e.g., a display apparatus based on LED type light emitting elements using an organic material, or a luminescent material display apparatus based on plasma discharge and ultraviolet ray excitation. To sum up, any luminescent display panel in which pixels are arranged in the form of a matrix and the respective pixels are driven by scanning lines and signal lines formed in directions substantially orthogonal to each other can demonstrate the advantages of the invention.

In addition, the back side wirings may be formed by screen printing using an Ag paste. In particular, when the scanning line wirings or the signal line wirings of the substrate are formed by the Ag paste wirings, warpage of the glass substrate due to thermal expansion can be advantageously minimized.

### Industrial Applicability

According to the present invention, since there is adopted a structure that the back side wirings are provided to connect the both ends of at least either the scanning line wirings or the signal line wirings, it is possible to realize a matrix type display panel which has the same excellent image quality as that obtained from two-side driving, superior in evenness of display with the same minimum number of drive ICs as that in the conventional one-side driving, minimizes power consumption, and has a stable operation with reduced electromagnetic radiant noise.

## Claims

1. A matrix type display apparatus comprising:
a display panel having a first main surface on which a display image is displayed and a second main surface substantially parallel to the first main surface;
a plurality of scanning line wirings provided to the display panel and parallel to each other;
a plurality of signal line wirings provided in a direction crossing the plurality of scanning line wirings and parallel to each other;
a plurality of display pixels which are defined at respective intersections of the plurality of scanning line wirings and the plurality of signal line wirings and independent of each other; and
a plurality of back side wirings formed on the second main surface of the display panel and connected with at least one of the plurality of scanning line wirings and the plurality of signal line wirings at opposed end portions of the display panel.

2. The matrix type display apparatus according to claim 1, further comprising a drive IC connected to the plurality of back side wirings at a substantial center in the second main surface of the display panel, wherein the drive IC applies a drive voltage to the plurality of scanning line wirings through the plurality of back side wirings.

3. The matrix type display apparatus according to claim 1, wherein the plurality of back side wirings are one kind of wirings selected from the group consisting of wirings formed from a metal thin film including Cu, wirings formed from a metal foil, and screen printed wirings including Ag.

4. The matrix type display apparatus according to claim 1, further comprising shields which are provided in a direction orthogonal to an extending direction of the plurality of back side wirings at positions opposite to the opposed end portions of the display panel, and used to prevent electromagnetic radiant noise.

5. A matrix type luminescent material display apparatus comprising:
a first substrate having a first main surface and a second main surface substantially parallel to the first main surface; and
a second substrate arranged to be opposed to the first main surface of the first substrate while maintaining a predetermined gap therebetween in vacuum, having a third main surface opposed to the first main surface and a fourth main surface substantially parallel to the third main surface and made of a transparent material,
the first substrate comprising:
a plurality of scanning line wirings provided on the first main surface and parallel to each other;
a plurality of signal line wirings provided on the first main surface in a direction crossing the plurality of scanning line wirings, and parallel to each other;
a plurality of display pixels defined at respective intersections of the plurality of scanning line wirings and the plurality of signal line wirings, formed of field emission type electron sources, and independent of each other; and
a plurality of back side wirings provided on the second main surface and connected with at least one of the plurality of scanning line wirings and the plurality of signal line wirings at opposed end portions of the first substrate,
the second substrate comprising:
an anode electrode formed on the third main surface to apply a voltage; and
an electron beam excited type luminescent material layer formed on the third main surface.

6. The matrix type luminescent material display apparatus according to claim 5, wherein the electron sources are planar electron sources, and the plurality of back side wirings are connected with the plurality of scanning line wirings to which a selection pulse of the display pixels is applied.

7. The matrix type luminescent material display apparatus according to claim 5, further comprising a drive IC connected to the plurality of back side wirings at a substantial center in the fourth main surface of the second substrate, wherein the drive IC applies a drive voltage to the plurality of scanning line wirings through the plurality of back side wirings.

8. The matrix type luminescent material display apparatus according to claim 5, wherein the plurality of back side wirings are one kind of wirings selected from the group consisting of wirings formed from a metal thin film including Cu, wirings formed from a metal foil, and screen printed wirings including Ag.

9. The matrix type luminescent material display apparatus according to claim 5, further comprising shields which are provided in a direction orthogonal to an extending direction of the plurality of back side wirings at positions opposite to both end portions of the second substrate, and used to prevent electromagnetic radiant noise.

10. The matrix type luminescent material display apparatus according to claim 5, wherein the plurality of signal line wirings or the plurality of signal line wirings formed on the first main surface of the first substrate are connected with the plurality of back side wirings formed on the second main surface via through holes formed in the first substrate.

11. A matrix type display apparatus comprising:
a substrate having a first main surface and a second main surface substantially parallel to the first main surface;
a plurality of scanning line wirings provided on the first main surface and parallel to each other;
a plurality of signal line wirings provided on the first main surface in a direction crossing the plurality of scanning line wirings, and parallel to each other;
a plurality of display pixels defined at respective intersections of the plurality of scanning line wirings and the plurality of signal line wirings, made of a luminescent layer driven by a current or an electric field, and independent of each other; and
a plurality of back side wirings provided on the second main surface and connected with at least one of the plurality of scanning line wirings and the plurality of signal line wirings at opposed end portions of the substrate.

12. The matrix type display apparatus according to claim 11, further comprising a drive IC connected with the plurality of back side wirings at a substantial center in the second main surface of the substrate, wherein the drive IC applies a drive voltage to the plurality of scanning line wirings through the plurality of back side wirings.

13. The matrix type display apparatus according to claim 11, wherein the plurality of the back side wirings are one kind of wirings selected from the group consisting of wirings formed from a metal thin film including Cu, wirings formed from a metal foil, and screen printed wirings including Ag.

14. The matrix type display apparatus according to claim 11, further comprising shields provided in a direction orthogonal to an extending direction of the plurality of back side wirings at positions opposite to the opposed end portions of the second substrate, and used to prevent electromagnetic radiant noise.

15. The matrix type display apparatus according to claim 11, wherein the plurality of scanning line wirings or the plurality of signal line wirings formed on the first main surface of the substrate are connected with the plurality of back side wirings formed on the second main surface via through holes formed in the substrate.

16. A matrix type luminescent material display apparatus comprising:
a first substrate having a first main surface and a second main surface substantially parallel to the first main surface, and made of a transparent material; and
a second substrate arranged so as to be opposed to the first main surface of the first substrate while maintaining a predetermined gap therebetween in a discharge gas, and having a third main surface opposed to the first main surface and a fourth main surface substantially parallel to the third main surface,
the first substrate comprising a plurality of scanning line wirings provided on the first main surface and parallel to each other,
the second substrate comprising:
a plurality of signal line wirings provided on the third main surface in a direction crossing the plurality of scanning line wirings of the first substrate, and parallel to each other;
an ultraviolet ray excited type luminescent material layer formed on the third main surface at least at positions corresponding to a plurality of display pixels which are defined at respective intersections of the plurality of scanning line wirings and the plurality of signal line wirings and independent of each other; and
a plurality of back side wirings provided on the fourth main surface and connected with at least one of the plurality of scanning line wirings and the plurality of signal line wirings at opposed end portions of the second substrate.

17. The matrix type luminescent material display apparatus according to claim 16, further comprising a drive IC connected with the plurality of back side wirings at a substantial center in the fourth main surface of the second substrate, wherein the drive IC applies a drive voltage to the plurality of scanning line wirings through the plurality of back side wirings.

18. The matrix type luminescent material display apparatus according to claim 16, wherein the plurality of back side wirings are one kind of wirings selected from the group consisting of wirings formed from a metal thin film including Cu, wirings formed from a metal foil, and screen printed wirings including Ag.

19. The matrix type luminescent material display apparatus according to claim 16, further comprising shields provided in a direction orthogonal to an extending direction of the plurality of back side wirings at positions opposite to the opposed end portions of the second substrate, and used to prevent electromagnetic radiant noise.

20. The matrix type luminescent material display apparatus according to claim 16, wherein the plurality of scanning line wirings or the plurality of signal line wirings formed on the first main surface of the first substrate are connected with the plurality of back side wirings formed on the second main surface via through holes formed in the first substrate.
